(19)

**Europäisches Patentamt**

**European Patent Office**

**Office européen des brevets**

(11) **EP 4 343 436 A1**

(12) **EUROPEAN PATENT APPLICATION**

(43) Date of publication:
**27.03.2024 Bulletin 2024/13**

(51) International Patent Classification (IPC):
***G03F 7/20*** (2006.01)   ***G03F 9/00*** (2006.01)

(21) Application number: **22196619.5**

(22) Date of filing: **20.09.2022**

(52) Cooperative Patent Classification (CPC):
**G03F 7/70458; G03F 7/70466; G03F 9/7069**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventor: **VAN DE KERKHOF, Marcus, Adrianus
Veldhoven (NL)**

(74) Representative: **ASML Netherlands B.V.
Corporate Intellectual Property
P.O. Box 324
5500 AH Veldhoven (NL)**

(54) **OPTICAL ALIGNMENT SYSTEM AND METHOD**

(57)     An optical alignment system comprising an illumination system configured to condition a radiation beam to form a first off-axis monopole, a marker configured to diffract the first off-axis monopole to form zeroth and first diffraction orders, a projection system configured to collect the zeroth and first diffraction orders and form an image of the marker, and a sensor apparatus configured to detect the image of the marker.

FIG. 1

## Description

FIELD

The present disclosure relates to an optical alignment system and method. An optical alignment system may be suitable for use in a lithographic apparatus. The present disclosure has particular use in connection with EUV lithographic apparatus and EUV lithographic tools.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A lithographic apparatus may comprise an optical alignment system which may be used to determine and improve an alignment between the patterning device and the substrate. The patterning device may include a marker that may be imaged by a projection system of the lithographic apparatus. The marker may impart a radiation beam with a mark which may subsequently be measured in order to derive one or more properties of the lithographic apparatus. The optical alignment system may comprise a sensor apparatus configured to detect the image of the marker and thereby determine a position of the substrate relative to the patterning device.

It may be desirable to provide an optical alignment system which overcomes or mitigates a problem associated with the prior art. Embodiments of the invention which are described herein may have use in an EUV lithographic apparatus. Embodiments of the invention may also have use in a DUV lithographic apparatus or another form of lithographic apparatus.

SUMMARY

According to a first aspect of the present disclosure, there is provided an optical alignment system comprising an illumination system configured to condition a radiation beam to form a first off-axis monopole. The optical alignment system comprises a marker configured to diffract the first off-axis monopole to form zeroth and first diffraction orders. The optical alignment system comprises a projection system configured to collect the zeroth and first diffraction orders and form an image of the marker. The optical alignment system comprises a sensor apparatus configured to detect the image of the marker.

The optical alignment system may be suitable for use in a lithographic apparatus. Radiation which is reflected from the marker may enter a projection system of a lithographic apparatus. Radiation which is reflected from the marker may be projected by a projection system onto a sensor placed at or near to an image plane of the projection system.

Off-axis may refer to an axis of the optical alignment system. The off-axis monopole may comprise illuminating only one region of a pupil of the projection system. The monopole may be positioned within the pupil such that the monopole is centred away from a centre of the pupil (e.g. one half of the pupil plane, or one quadrant of the pupil plane), and is thereby off-axis relative to the pupil.

The inventors have found that the relatively large and isolated features of known markers in known optical alignment systems do not provide accurate alignment measurements when illuminated using an off-axis monopole. This is because the images formed by known markers are severely skewed and extremely non-telecentric. This skewed and non-telecentric behavior results in unwanted positional shifts of the image formed by the marker that are subsequently detected by the sensor apparatus. Focus fluctuations between different off-axis monopole illuminations may cause further unwanted positional shifts of the image formed by the marker.

The marker of the present disclosure advantageously diffracts the off-axis monopole in order to fill more of a pupil of the optical alignment system, thereby reducing a skew and increasing a telecentricity of the image formed by the marker compared to known markers. The marker of the present disclosure may advantageously improve a balance of radiation across different regions of a pupil of the projection system compared to known markers. For example, the zeroth diffraction order may at least partially fill a first half of the pupil and the first diffraction order may at least partially fill a second half of the pupil. This is advantageous when the radiation reflected from the marker and output from the projection system is measured for the purposes of determining an alignment of components of the lithographic apparatus. In general, measurements of radiation output from the projection system may be made at or near to a substrate level of the lithographic apparatus, which may correspond with an image plane of the projection system. In such embodiments it may be desirable for radiation to substantially fill the pupil of the projection system.

The optical alignment system of the present invention thereby advantageously improves an accuracy of optical alignment measurements performed using off-axis monopole illumination, compared to known systems.

The marker may comprise a plurality of reflective regions configured to preferentially reflect the radiation beam. The marker may comprise a plurality of absorbing regions configured to preferentially absorb the radiation beam. The reflective regions and the absorbing regions may be arranged to form a reflective diffraction grating.

References herein to a reflective region being configured to preferentially reflect radiation of a given wavelength should be interpreted to mean that the reflective region is configured such that the reflectivity of the reflective region is higher at the given wavelength than at other wavelengths. The reflective region may additionally reflect radiation having wavelengths other than the given wavelength.

A reflective region may, for example, comprise a multilayer structure comprising layers of two or more materials having different refractive indices. Radiation may be reflected from interfaces between different layers. The layers may be arranged to provide a separation between interfaces which causes constructive interference between radiation reflected at different interfaces. The separation between interfaces which causes constructive interference between radiation reflected at different interfaces depends on the wavelength of the radiation. A multilayer reflective region may therefore be configured to preferentially reflect radiation of a given wavelength by providing a separation between layer interfaces which causes constructive interference between radiation of the given wavelength reflected from different interfaces.

The reflective regions may be disposed on an absorbing layer, and the absorbing regions may comprise regions of the absorbing layer on which no reflective regions are disposed.

The radiation beam may comprise extreme-ultraviolet radiation.

A pitch of the reflective diffraction grating may be of the order of a wavelength of the extreme ultraviolet radiation.

A minimum pitch of the reflective diffraction grating may be determined by the following equation:

$$P_{min} > 0.5 \times \frac{\lambda}{NA}$$

wherein $\lambda$ is a wavelength of the radiation beam and NA is a numerical aperture of the projection system.

A maximum pitch of the reflective diffraction grating may be less than about double the minimum pitch.

The pitch of the reflective diffraction grating may be within the inclusive range of about 24 nm to about 44 nm. The pitch of the reflective diffraction grating may be about 28 nm.

The reflective diffraction grating may comprise terminal reflective and absorbing regions and non-terminal reflective and absorbing regions located between the terminal reflective and absorbing regions. A duty cycle of the terminal reflective and absorbing regions may be different to a duty cycle of the non-terminal reflective and absorbing regions.

A duty cycle of the non-terminal reflective and absorbing regions may be about 50% reflective region to about 50% absorbing region (i.e. about 50:50). A duty cycle of the terminal reflective regions may not be about 50:50. An extent of the terminal reflective regions along a pitch of the reflective diffraction grating may be greater or lesser than an extent of the non-terminal reflective regions. Introducing a difference in the duty cycle of the terminal reflective regions may advantageously reduce or avoid a non-telecentricity associated with terminal regions of the reflective diffraction grating.

The marker may comprise a sub-resolution alignment feature.

Sub-resolution alignment features may be considered to be features that are small enough such that they do not result in a significant feature of their own after the lithographic steps of develop and etch, whilst still being large enough to influence imaging of neighboring features. As such, the size and form of sub-resolution features may at least partially depend upon the processes used and may be substrate layer-specific. In general, any feature that is less than half the size of the feature that is to be imaged by the projection system may be considered to be "sub-resolution".

According to a second aspect of the present disclosure, there is provided a marker for use in the optical alignment system of the first aspect of the present disclosure.

According to a third aspect of the present disclosure, there is provided a lithographic apparatus comprising the optical alignment system of the first aspect of the present disclosure. The lithographic apparatus comprises a support structure constructed to support a patterning device, the patterning device being capable of imparting the off-axis monopole with a pattern in its cross-section to form a patterned radiation beam. The marker forms part of the support structure or the patterning device. The lithographic apparatus comprises a substrate table constructed to hold a substrate. The sensor apparatus forms part of the substrate table. The projection system is configured to project the patterned radiation beam onto the substrate. The optical alignment system is configured to determine an alignment between the patterning device and the substrate.

The illumination system may be configured to condition the radiation beam to form a second off-axis monopole. The first off-axis monopole and the second off-axis monopole may be located in different regions of a pupil plane of the lithographic apparatus.

The lithographic apparatus may be configured to perform a first lithographic exposure using the first off-axis monopole to form a first image of the patterning device on the substrate. The lithographic apparatus may be configured to perform a second lithographic exposure using the second off-axis monopole to form a second image of the patterning device on the substrate. The substrate table may be configured to move between the first lithographic exposure and the second lithographic exposure such that the first and second images of the patterning device substantially overlap on the substrate.

According to a fourth aspect of the present disclosure, there is provided an optical alignment method comprising conditioning a radiation beam to form a first off-axis monopole. The optical alignment method comprises diffracting the first off-axis monopole to form zeroth and first diffraction orders. The optical alignment method comprises collecting the zeroth and first diffraction orders. The optical alignment method comprises forming an image using the zeroth and first diffraction orders. The optical alignment method comprises detecting the image.

According to a fourth aspect of the present disclosure, there is provided a lithographic exposure method comprising using the optical alignment method of the fourth aspect of the present disclosure to determine an alignment between a patterning device and a substrate. The lithographic exposure method comprises using the patterning device to impart the off-axis monopole with a pattern in its cross-section to form a patterned radiation beam. The lithographic exposure method comprises projecting the patterned radiation beam onto the substrate.

The lithographic exposure method may comprise conditioning the radiation beam to form a second off-axis monopole. The first off-axis monopole and the second off-axis monopole may be located in different regions of a pupil plane.

The lithographic exposure method may comprise performing a first lithographic exposure using the first off-axis monopole to form a first image of the patterning device on the substrate. The lithographic exposure method may comprise performing a second lithographic exposure using the second off-axis monopole to form a second image of the patterning device on the substrate. The lithographic exposure method may comprise moving the substrate between the first lithographic exposure and the second lithographic exposure such that the first and second images of the patterning device substantially overlap on the substrate.

Features of different aspects of the present disclosure may be combined with features of other aspects of the present disclosure.

BRIEF DESCRIPTION OF THE DRAWINGS

Embodiments of the invention will now be described, by way of example only, with reference to the accompanying schematic drawings, in which:

- Fig. 1 schematically depicts a lithographic system comprising a lithographic apparatus, a radiation source and an optical alignment system according to the present disclosure.
- Fig. 2A schematically depicts a lithographic exposure performed using a dipole illumination mode.
- Fig. 2B shows a graph of the intensity of the constituent aerial images and the composite aerial image formed by the lithographic exposure of Fig. 2A as a function of position at wafer level.
- Fig. 3A schematically depicts a first off-axis monopole exposure of a dual monopole lithographic exposure.
- Fig. 3B schematically depicts a second off-axis monopole exposure of the dual monopole lithographic exposure.
- Fig. 4A schematically depicts a known marker alongside a pupil plane view of an off-axis monopole used to illuminate the known marker.
- Fig. 4B schematically depicts a marker configured to diffract an off-axis monopole according to the present disclosure.
- Fig. 5 shows a flowchart of an optical alignment method according to the present disclosure.

DETAILED DESCRIPTION

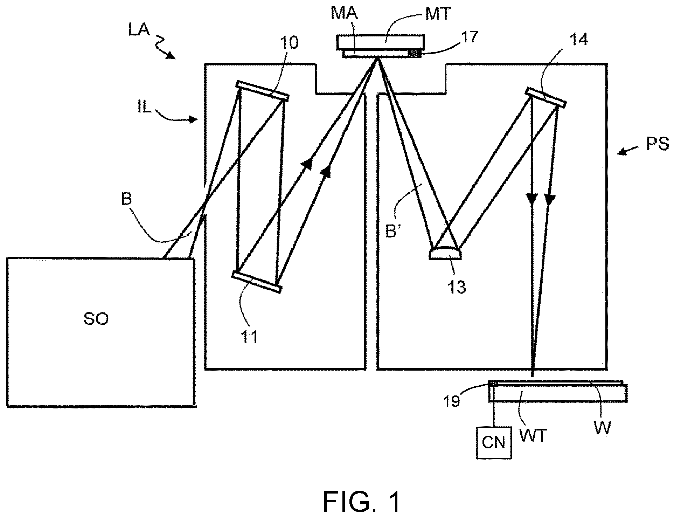

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

As has been described above, a lithographic apparatus may be used to expose portions of a substrate W in order to form a pattern in the substrate W. In order to improve the accuracy with which a desired pattern is transferred to a substrate W one or more properties of the lithographic apparatus LA may be measured. Such properties may be measured on a regular basis, for example before and/or after exposure of each substrate W, or may be measured more infrequently, for example, as part of a calibration process. Examples of properties of the lithographic apparatus LA which may be measured include a relative alignment of components of the lithographic apparatus LA. For example, measurements may be made in order to determine the relative alignment of the support structure MT for supporting a patterning device MA and the substrate table WT for supporting a substrate W. Determining the relative alignment of the support structure MT and the substrate table WT assists in projecting a patterned radiation beam onto a desired portion of a substrate W. This may be particularly important when projecting patterned radiation onto a substrate W which includes portions which have already been exposed to radiation, so as to improve alignment of the patterned radiation with the previously exposed regions.

Measurements, such as the alignment measurement described above may be performed by illuminating a reflective marker 17 (as schematically shown in Figure 1) with radiation. A marker 17 is a reflective feature which when placed in the field of view of an optical system (such as the lithographic apparatus LA of Fig. 1) appears in an image produced by the optical system. Reflective markers described herein are suitable for use as a point of reference and/or for use as a measure of properties of the image formed by the optical system. For example, radiation reflected from a reflective marker may be used to determine an alignment of one or more components of the optical system.

In the embodiment which is shown in Figure 1, the reflective marker 17 forms part of a patterning device MA. One or more markers 17 may be provided on patterning devices MA used to perform lithographic exposures. A marker 17 may be positioned outside of a patterned region of the patterning device MA, which is illuminated with radiation during a lithographic exposure. In some embodiments, one or more markers 17 may additionally or alternatively be provided on the support structure MT. For example, a dedicated piece of hardware, often referred to as a fiducial, may be provided on the support structure MT. A fiducial may include one or more markers. For the purposes of this description a fiducial is considered to be an example of a patterning device. In some embodiments, a patterning device MA specifically designed for measuring one or more properties of the lithographic apparatus LA may be placed on the support structure MT in order to perform a measurement process. The patterning device MA may include one or more markers 17 for illumination as part of a measurement process.

In the embodiment which is shown in Figure 1, the lithographic apparatus LA is an EUV lithographic apparatus and therefore uses a reflective patterning device MA. The marker 17 is thus a reflective marker 17. The configuration of a marker 17 may depend on the nature of the measurement which is to be made using the marker 17. Known markers comprise one or more reflective pinhole features comprising a reflective region surrounded by an absorbing region, a reflective line feature, an arrangement of a plurality of reflective line features, etc.

In order to measure one or more properties of the lithographic apparatus LA, a sensor apparatus 19 (as shown schematically in Figure 1) is provided to measure radiation which is output from the projection system PS. The sensor apparatus 19 may, for example, be provided on the substrate table WT as shown in Figure 1. In order to perform a measurement process, the support structure MT may be positioned such that the marker 17 on the patterning device MA is illuminated with radiation. The substrate table WT may be positioned such that radiation which is reflected from the marker is projected, by the projection system PS, onto the sensor apparatus 19. The sensor apparatus 19 is in communication with a controller CN which may determine one or more properties of the lithographic apparatus LA from the measurements made by the sensor apparatus 19. In some embodiments a plurality of markers 17 and/or sensor apparatuses 19 may be provided and properties of the lithographic apparatus LA may be measured at a plurality of different field points (i.e. locations in a field or object plane of the projections system PS).

As was described above, in some embodiments radiation reflected from a marker may be used to determine a relative alignment of components of the lithographic apparatus LA. In such embodiments, a marker 17 may comprise a feature which when illuminated with radiation imparts the radiation with an alignment feature. The feature may, for example, comprise one or more reflective patterns in the form of a grating structure.

The position of the alignment feature in the radiation beam B may be measured by a sensor apparatus 19 positioned at a substrate W level (e.g. on the substrate table WT as shown in Figure 1). The sensor apparatus 19 may be operable to detect the position of an alignment feature in the radiation incident upon it. This may allow the alignment of the substrate table WT relative to the marker on the pattering device MA to be determined. With knowledge of the relative alignment of the patterning device MA and the substrate table WT, the patterning device MA and the substrate table WT may be moved relative to each other so as to form a pattern (using the patterned radiation beam B reflected from the patterning device MA) at a desired location on the substrate W. The position of the substrate W on the substrate table WT may be determined using a separate measurement process.

The sensor apparatus 19 may, for example, be a Transmission Image Sensor (TIS). A TIS is a sensor that may be used to measure the position at substrate W level of a projected aerial image of a marker 17 at the mask (reticle) MA level. The TIS is configured to measure the image of the mark 17 using a transmission pattern with a radiation sensor located underneath the transmission pattern. The measurement data produced by the sensor apparatus may be used to measure the position of the mask MA with respect to the substrate table WT in six degrees of freedom (three in translation and three in rotation). In addition, the magnification and scaling of the projected image of the marker 17 may be measured.

The illumination system IL may be configured to condition the radiation beam B to form different illumination modes. The illumination modes may be defined by the number of regions of the pupil plane of the lithographic apparatus LA that are illuminated by the radiation beam B. For example, a dipole illumination mode may comprise two opposing portions of the pupil plane that are illuminated with radiation, a quadrupole illumination mode may comprise four regions of the pupil plane that are illuminated with radiation, etc. The pupil plane may be defined by the numerical aperture (NA) of the lithographic apparatus LA. That is, the pupil plane may be defined by the maximum angular distribution of radiation accepted by the lithographic apparatus LA. The pupil plane may be a Fourier transform plane of the plane in which the substrate W is disposed (which may be referred to as an object plane). Therefore, the distribution of electric field strength of the radiation in the pupil plane may be related to a Fourier transform of an object (for example, the mark 17) disposed in the object plane. In particular, the distribution of electric field strength of the radiation in the pupil plane (i.e. the angular distribution of radiation that is scattered by the object, such as the mark 17) may be given by a convolution of: (a) the distribution of Electric field strength of the radiation in an illumination pupil plane (i.e. the angular distribution of radiation that illuminates the object, e.g. the mark 17) and (b) a Fourier transform of the object.

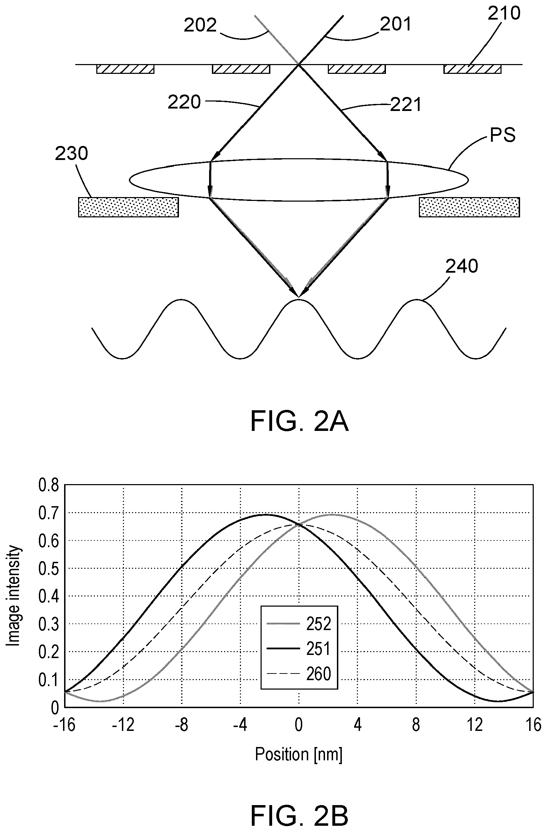

Some errors may occur when using multi-pole illumination modes. Fig. 2A schematically depicts a lithographic exposure performed using a dipole illumination mode. The lithographic exposure may be performed using the lithographic apparatus LA of Fig. 1. In the example of Fig. 2A, the dipole illumination mode comprises a right pole 201 and a left pole 202. The right and left poles 201, 202 (i.e. the dipole) are incident on a patterning device comprising a grating mask 210. The dipole is formed of EUV radiation, and the grating mask 210 may, for example, have a pitch of about 32 nm. It will be appreciated that in practice the grating mask 210 is a reflective grating mask configured to reflect the dipole 201, 202. However, in the example of Fig. 2A the dipole 201, 202 is shown as transmitting through the grating mask 210 in order to simplify, and thereby aid understanding of, the schematic drawing. The dipole 201, 202 undergoes diffraction upon interacting with the grating mask 210 and forms a plurality of diffraction orders 220, 221. The right pole 201 diffracts to produce zeroth and first diffraction orders 220, 221 and the left pole diffracts to produce zeroth and first diffraction orders 220, 221. The other diffraction orders (e.g. the second, third, fourth, etc. diffraction orders) are not collected by the projection system PS because they propagate at large angles that do not enter the limited numerical aperture of the projection system PS. In the example of Fig. 2A, the zeroth diffraction orders 220 and the first diffraction orders 221 are collected by the projection system PS and are focussed through an aperture 230 and to form an aerial image 240 of the grating mask 210. At EUV wavelengths, the grating mask 210 interacts with the dipole 201, 202 as a three-dimensional structure rather than a two-dimensional pattern. The three-dimensional effects at EUV wavelengths introduce a phase shift between the zeroth diffraction orders 220 and the first diffraction orders 221. The phase shift itself results in a positional shift of constituent aerial images formed by the right and left poles 201, 202 of the dipole. The constituent aerial images combine to form a composite aerial image.

Fig. 2B shows a graph of the intensity of the constituent aerial images 251 252 and the composite aerial image 260 formed by the lithographic exposure of Fig. 2A as a function of position at wafer level. The positional shift experienced by the constituent aerial image 251 formed by the right pole 201 is in a direction that is opposite to the positional shift experienced by the constituent aerial image 252 formed by the left pole 202. In the example of Fig. 2B, the constituent aerial image 251 formed by the right pole 201 is shifted by about -3 nm and the constituent aerial image 252 formed by the left pole 202 is shifted by about +3 nm. The composite aerial image 260 formed by combining the right and left pole constituent aerial images 251, 252 thereby suffers a reduced image contrast compared to the constituent aerial images 251, 252 when taken alone. In general, the smaller the pitch of the grating mask 210, the worse the reduction of image contrast. It is desirable to maximise image contrast. On the other hand, it may be desirable to use dipole illumination in order to maximise depth of focus.

Another type of illumination mode provided by the illumination system IL may be referred to as an off-axis monopole illumination mode. The off-axis monopole illumination mode comprises illuminating only one region of the pupil plane that is centred away from a centre of the pupil plane (e.g. one half of the pupil plane, or one quadrant of the pupil plane). The off-axis monopole illumination mode has a single position of best focus at the substrate W. As such, using the off-axis monopole illumination mode advantageously avoids the image contrast errors that result from different positions of best focus associated with traditional multi-pole illumination modes. This avoidance of errors advantageously enables previously unprintable features to be printed by the lithographic apparatus LA and/or enables the use of less expensive and/or complex components (e.g. less expensive and/or complex reticles MA) in the lithographic apparatus LA when printing features.

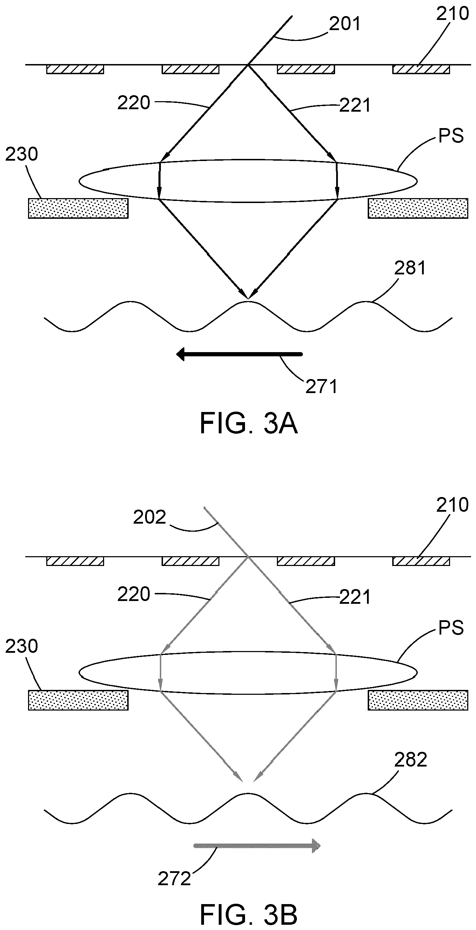

A further type of illumination mode provided by the illumination system IL may be referred to as a dual monopole illumination mode. The dual monopole illumination mode involves splitting a traditional dipole illumination mode into a first off-axis monopole exposure corresponding to the right or left pole, and a second off-axis monopole exposure corresponding to the other pole. Each off-axis monopole exposure uses half the dose of illumination radiation that would have been used in a traditional dipole exposure. Fig. 3A schematically depicts a first off-axis monopole exposure of a dual monopole lithographic exposure. In the example of Fig. 3A, the first off-axis monopole corresponds to the right pole 201 of the dipole of Fig. 2A. The dual monopole exposure involves moving the wafer stage to account for the positional shifts experienced by the constituent aerial images 251, 252 formed by the right and left poles 201, 202. In the example of Fig. 3A, the wafer stage is moved from a centre position by about -3 nm to account for the positional shift of the constituent aerial image formed by the right pole. A first arrow 271 is used to depict the movement of the wafer stage. The right pole 201 is diffracted by the grating mask 210. The zeroth diffraction order 220 and the first diffraction order 221 are collected by the projection system PS and focussed through the aperture 230 to form a first aerial image 281. Given that half the dose of a traditional dipole exposure is used, the first aerial image 281 formed by the first off-axis monopole exposure has half the intensity of the constituent aerial image 240 formed by the lithographic exposure of Fig. 2A.

Fig. 3B schematically depicts a second off-axis monopole exposure of the dual monopole lithographic exposure. In the example of Fig. 3B, the second off-axis monopole corresponds to the left pole 202 of the dipole of Fig. 2A. To account for the positional shift experienced by the constituent aerial image formed by the left pole, in the example of Fig. 3B the wafer stage is moved from the centre position by about +3 nm. A second arrow 272 is used to depict the movement of the wafer stage. The left pole 202 is diffracted by the grating mask 210. The zeroth diffraction order 220 and the first diffraction order 221 are collected by the projection system PS and focussed through the aperture 230 to form a second aerial image 282. Given that half the dose of a traditional dipole exposure is used, the second aerial image 282 formed by the second off-axis monopole exposure has half the intensity of the constituent aerial image 240 formed by the lithographic exposure of Fig. 2A. By shifting the wafer stage such that the first and second aerial images 281, 282 effectively overlap the same position, the composite aerial image formed by the first aerial image 281 and the second aerial image 282 has an increased image contrast compared to the composite aerial image 260 of Fig. 2B. That is, dual monopole illumination (e.g. Fig. 3A, B) avoids the image contrast loss associated with traditional dipole illumination (e.g. Fig. 2A, B). The image contrast of the composite aerial image formed by the first aerial image 281 and the second aerial image 282 may be equivalent to the image contrast of each of the constituent aerial images 281, 282 formed by the first and second off-axis monopole exposures. It will be appreciated that the dual monopole exposure requires two separate exposures rather than a single exposure, which takes more time and thereby introduces a throughput penalty compared to traditional dipole exposures. As such, dual monopole exposures may be reserved for particularly complicated mask patterns for which the improvement of image contrast is worth the reduction of throughput.

Known optical alignment system markers (e.g. known TIS markers) comprise relatively large and isolated features. That is, the size and/or pitch of a known marker may be significantly greater than a wavelength of radiation that is used to illuminate the known marker. This is because using relatively large and isolated features may be beneficial for creating an aerial image that is measurable for a variety of multi-pole illumination modes. For example, known EUV markers have an area of about 100-500 $\mu$m by about 100-500 $\mu$m, and consist of large, isolated lines (e.g. having either horizontal or vertical orientation) with a line width in order of about 100 nm to 200 nm and a spacing of about 1 $\mu$m to about 10 $\mu$m.

Known markers comprise sets of large, isolated lines. The features (e.g. lines) are herein described as being isolated because a spacing between the features is so large that no separate interference lines are observed, and the diffraction pattern generated by said features is governed by a size (e.g. a line width), and not by the spacing. Multiple isolated lines may form a set that is used as a measurement mark to increase the total measured signal and improve a signal-to-noise ratio of the measurement. In some cases, the spacing between the isolated lines in a set is substantially constant, resulting in a grating-like structure. However, as previously discussed, the spacing between the lines in the grating-like structure is so large that no separate interference lines are observed, and the diffraction pattern generated by said lines is governed by the line width, and not by the spacing. That is the grating-like structure does not act as a diffraction grating.

Different reticles MA may require the use of different illumination modes for best performance. A set of known markers comprising relatively large and isolated features may be placed on different reticles MA and may provide adequate aerial images for alignment measurements across a variety of multi-pole illumination modes. However, the relatively large and isolated features of known markers do not provide accurate alignment measurements when illuminated using an off-axis monopole exposure.

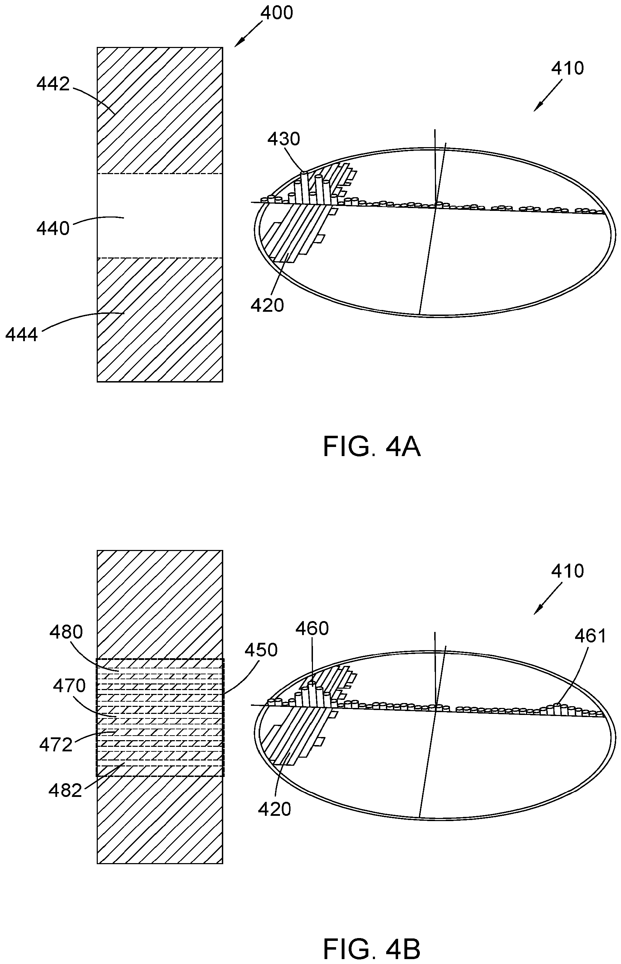

Fig. 4A schematically depicts a known marker 400 alongside a pupil plane view 410 of an off-axis monopole 420 used to illuminate the known marker 400. The known marker 400 comprises a reflective region 440 located between two absorbing regions 442, 444. Light reflected from the reflective region 440 is collected by a projection system (not shown) which forms an aerial image 430 of the reflective portion 440. An intensity 430 of an aerial image of the reflective portion 440 is shown along an axis of the pupil plane 410. In the example of Fig. 4A, the off-axis monopole 420 is located solely on a left side of the pupil plane 410. Likewise, the aerial image 430 of the reflective portion is located solely on the left side of the pupil plane 410. The aerial image 430 formed by the known marker 400 is severely skewed and extremely non-telecentric due to the relatively limited and asymmetric angular distribution of the off-axis monopole 420. This non-telecentric behaviour results in an unwanted positional shift of the aerial image 430 at the sensor apparatus. When used as part of a lithographic apparatus, this unwanted positional shift may in turn lead to overlay errors.

Fig. 4B schematically depicts a marker 450 configured to diffract an off-axis monopole 420 according to an embodiment of the present disclosure. The marker 450 is shown alongside a pupil plane view 410 of an off-axis monopole 420 used to illuminate the marker 450. The marker is configured to diffract the off-axis monopole 420 to form zeroth and first diffraction orders 460, 461. In the example of Fig. 4B, the zeroth diffraction order 460 is located on a left side of the pupil plane 410 and the first diffraction order 461 is located on a right side of the pupil plane 410. The aerial image 460, 461 therefore has a reduced skew and greater telecentricity than the aerial image 430 of Fig. 4A (which is solely located on the left side of the pupil plane 410. A projection system (not shown), such as the projection system PS of Fig. 1, is configured to collect the zeroth and first diffraction orders 460, 461 and form an image of the marker 450. A sensor apparatus (not shown), such as the sensor apparatus 19 of Fig. 1, is configured to detect the image of the marker 450.

The marker 450 comprises a plurality of reflective regions 470 configured to preferentially reflect the off-axis monopole 420 and a plurality of absorbing regions 472 configured to preferentially absorb the off-axis monopole 420. The reflective regions 470 and the absorbing regions 472 are arranged to form a reflective diffraction grating which diffracts the off-axis monopole 420. A reflective region 470 may, for example, comprise a multilayer structure comprising layers of two or more materials having different refractive indices. Radiation may be reflected from interfaces between different layers. The layers may be arranged to provide a separation between interfaces which causes constructive interference between radiation reflected at different interfaces. The separation between interfaces which causes constructive interference between radiation reflected at different interfaces depends on the wavelength of the radiation. A multilayer reflective region 470 may therefore be configured to preferentially reflect radiation of a given wavelength (e.g. EUV radiation) by providing a separation between layer interfaces which causes constructive interference between radiation of the given wavelength reflected from different interfaces. The reflective regions 470 may be disposed on an absorbing layer, and the absorbing regions 472 may comprise regions of the absorbing layer on which no reflective regions 470 are disposed.

In the example of Fig. 4B, the off-axis monopole 420 is formed of extreme-ultraviolet radiation. A pitch of the reflective diffraction grating formed by the reflective regions 470 and the absorbing regions 472 is of the order of a wavelength of the extreme ultraviolet radiation.

A minimum pitch of the reflective diffraction grating may be just large enough such that the zeroth and first diffraction orders 460, 461 only just fit into the pupil 410 (i.e. the zeroth and first diffraction orders are only just collected by the projection system). The minimum pitch of the reflective diffraction grating may be determined by the following equation:

$$P_{min} > 0.5 \times \frac{\lambda}{NA}$$

wherein $\lambda$ is a wavelength of the radiation beam and NA is a numerical aperture of the projection system. For example, for EUV radiation having a wavelength of about 13.5 nm and a projection system having a numerical aperture of about 0.33, the minimum pitch of the reflective diffraction grating may be about 24 nm. A maximum pitch of the reflective diffraction grating may be just small enough to prevent a second diffraction order from also fitting into the pupil 410 (i.e. the second diffraction order is only just prevented from entering the projection system). The maximum pitch of the reflective diffraction grating may be less than about double the minimum pitch. For example, for EUV radiation having a wavelength of about 13.5 nm and a projection system having a numerical aperture of about 0.33, the minimum pitch of the reflective diffraction grating may be about 44 nm. It will be appreciated that the maximum pitch is not a sharp limit, and is more of a practical consideration. Given the above, for example, the pitch of the reflective diffraction grating for an EUV lithographic apparatus may be about 28 nm.

For improved performance, a pitch of the marker may match an illumination mode of the illumination system to reduce or minimize non-telecentricity and/or skewness of the aerial image of the marker. That is, the marker according to the present invention acts to improve a distribution or balance of radiation across the pupil. A position of the zeroth diffraction order 460 within the pupil 410 may at least partially depend on the incoming radiation beam or illumination mode, which in turn may be selected in at least partial dependence upon a pitch of the structures to be imaged by the projection system (i.e. to create improved or optimum telecentricity for the structures to be imaged by the projection system). Once a position of the zeroth diffraction order 460 in the pupil 410 is determined, the first diffraction order 461 may be formed so as to substantially mirror the position of the zeroth diffraction order 460 in the pupil 410 by choosing an appropriate pitch of the marker.

The reflective diffraction grating 450 comprises terminal reflective regions 480, 482. The terminal reflective regions 480, 482 neighbor absorbing expanses that do not continue the pattern of reflective diffraction grating 450. As such, an asymmetry is present at the terminal reflective regions 480, 482 which may be perceived as a different pitch compared to the pitch of the non-terminal regions 470, 472 of the diffraction grating 450. The terminal reflective regions 480, 482 may introduce skew and/or non-telecentricity to the aerial image 460, 461 of the marker 450. In order to reduce this effect, a duty cycle of the terminal reflective regions 480, 482 may be different to a duty cycle of the non-terminal reflective and absorbing regions 470, 472 located between the terminal reflective regions 480, 482. For example, a duty cycle of the non-terminal reflective and absorbing regions 470, 472 may be about 50% reflective region 470 to 50% absorbing region 472 (i.e. 50:50). However, the duty cycle of the terminal reflective regions 480, 482 may not be 50:50. That is, an extent of the terminal reflective regions 480, 482 along the pitch of the reflective diffraction grating 450 may be greater or lesser than an extent of the non-terminal reflective regions. Adjusting a duty cycle of the terminal reflective regions may advantageously reduce or avoid the non-telecentricity associated with the ends of the reflective diffraction grating.

The marker 450 may comprise one or more sub-resolution alignment features. Sub-resolution alignment features may be considered to be features that are small enough such that they do not result in a significant feature of their own after the lithographic steps of develop and etch, whilst still being large enough to influence neighboring features. As such, the size and form of sub-resolution features at least partially depend upon the processes used and may be substrate layer-specific. In general, any feature that is less than half the size of the feature that is to be imaged by the projection system may be considered to be "sub-resolution".

Referring again to Fig. 1, the marker 450 of Fig. 4B may correspond to the marker 17 of Fig. 1. The marker 17 may form part of the support structure MT or the patterning device MA. The illumination system IS, marker 17, projection system PS and sensor apparatus 19 of Fig. 1 may together act as an optical alignment system. The lithographic apparatus LA may be used to perform a dual monopole exposure, such as the dual monopole exposure shown in Figs. 3A and 3B. The optical alignment system may be configured to determine and improve an alignment between the patterning device MA and the substrate W before the dual lithographic exposure is performed. For example, the illumination system IL may condition the radiation beam B to form a first off-axis monopole, such as the right off-axis monopole 201 shown in Fig. 3A. The optical alignment system may use the first off-axis monopole 201 to perform a measurement of the marker 17, similar to the measurement shown in Fig. 4B, to determine an alignment between the patterning device MA and the substrate W. The lithographic apparatus LA may then perform a first lithographic exposure using the first off-axis monopole 201 to form a first image 281 of the patterning device MA on the substrate W, such as the first monopole exposure shown in Fig. 3A. Alignment information determined by the optical alignment system may be used to ensure that the substrate table WT is moved 271 from a centre position to account for the positional shift of the constituent aerial image 281 formed by the first off-axis monopole 201. The illumination system IS may be configured to condition the radiation beam B to form a second off-axis monopole, such as the left monopole 202 shown in Fig. 3B. The first off-axis monopole 201 and the second off-axis monopole 202 are located in different regions (e.g. a left side and a right side) of a pupil plane of the lithographic apparatus LA. The lithographic apparatus LA may then perform a second lithographic exposure using the second off-axis monopole 202 to form a second image 282 of the patterning device MA on the substrate W, such as the second monopole exposure shown in Fig. 3B. Alignment information determined by the optical alignment system may be used to ensure that the substrate table WT is moved 272 from a centre position to account for the positional shift of the constituent aerial image 282 formed by the second off-axis monopole 202. That is, the substrate table WT is configured to move between the first lithographic exposure and the second lithographic exposure such that the first and second images 281, 282 of the patterning device MA substantially overlap on the substrate W.

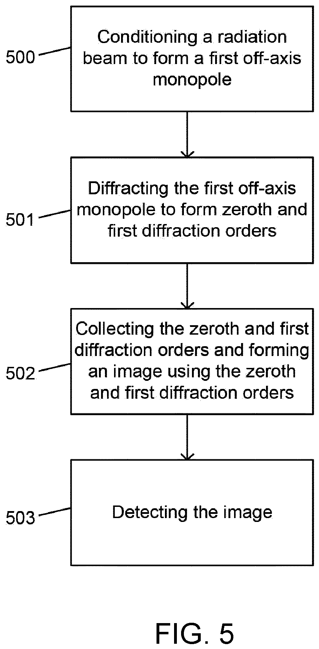

Fig. 5 shows a flowchart of an optical alignment method according to the present disclosure. A first step 500 of the method comprises conditioning a radiation beam to form a first off-axis monopole. A second step 501 of the method comprises diffracting the first off-axis monopole to form zeroth and first diffraction orders. A third step 502 of the method comprises collecting the zeroth and first diffraction orders and forming an image using the zeroth and first diffraction orders. A fourth step 503 of the method comprises detecting the image.

A first step of a lithographic exposure method may comprise using the optical alignment method of Fig. 5 to determine an alignment between a patterning device MA and a substrate W. A second step of the lithographic exposure method may comprise using the patterning device MA to impart the first off-axis monopole with a pattern in its cross-section to form a patterned radiation beam B'. A third step of the lithographic exposure method may comprise projecting the patterned radiation beam B' onto the substrate W, thereby performing a first lithographic exposure using the first off-axis monopole to form a first image of the patterning device MA on the substrate W. A fourth step of the lithographic exposure method may comprise conditioning the radiation beam B to form a second off-axis monopole. The first off-axis monopole and the second off-axis monopole may be located in different regions of a pupil plane of the lithographic apparatus LA. A fifth step of the lithographic exposure method may comprise performing a second lithographic exposure using the second off-axis monopole to form a second image of the patterning device MA on the substrate W. The lithographic exposure method may comprise using the alignment determined by the optical alignment method to move the substrate W between the first lithographic exposure and the second lithographic exposure such that the first and second images of the patterning device MA substantially overlap on the substrate W.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. An optical alignment system comprising:

   an illumination system configured to condition a radiation beam to form a first off-axis monopole;
   a marker configured to diffract the first off-axis monopole to form zeroth and first diffraction orders;
   a projection system configured to collect the zeroth and first diffraction orders and form an image of the marker; and,
   a sensor apparatus configured to detect the image of the marker.

2. The optical alignment system of claim 1, wherein the marker comprises:

   a plurality of reflective regions configured to preferentially reflect the radiation beam; and,
   a plurality of absorbing regions configured to preferentially absorb the radiation beam, wherein the reflective regions and the absorbing regions are arranged to form a reflective diffraction grating.

3. The optical alignment system of claim 2, wherein the radiation beam comprises extreme-ultraviolet radiation.

4. The optical alignment system of claim 2 or claim 3, wherein a minimum pitch of the reflective diffraction grating is determined by the following equation:

$$P_{min} > 0.5 \times \frac{\lambda}{NA}$$

wherein $\lambda$ is a wavelength of the radiation beam and NA is a numerical aperture of the projection system.

5. The optical alignment system of claim 3 or claim 4, wherein the pitch of the reflective diffraction grating is within the inclusive range of about 24 nm to about 44 nm.

6. The optical alignment system of any of claims 2 to 5, wherein the reflective diffraction grating comprises terminal reflective and absorbing regions and non-terminal reflective and absorbing regions located between the terminal reflective and absorbing regions, wherein a duty cycle of the terminal reflective and absorbing regions is different to a duty cycle of the non-terminal reflective and absorbing regions.

7. The optical alignment system of any of claims 2 to 6, wherein the marker comprises a sub-resolution alignment feature.

8. A marker for use in the optical alignment system of any of claims 1 to 7.

9. A lithographic apparatus comprising:

the optical alignment system of any of claims 1 to 8;
a support structure constructed to support a patterning device, the patterning device being capable of imparting the off-axis monopole with a pattern in its cross-section to form a patterned radiation beam, wherein the marker forms part of the support structure or the patterning device; and,
a substrate table constructed to hold a substrate, wherein the sensor apparatus forms part of the substrate table, wherein the projection system is configured to project the patterned radiation beam onto the substrate,
and wherein the optical alignment system is configured to determine an alignment between the patterning device and the substrate.

10. The lithographic apparatus of claim 9, wherein the illumination system is configured to condition the radiation beam to form a second off-axis monopole, wherein the first off-axis monopole and the second off-axis monopole are located in different regions of a pupil plane of the lithographic apparatus.

11. The lithographic apparatus of claim 10, wherein the lithographic apparatus is configured to:

perform a first lithographic exposure using the first off-axis monopole to form a first image of the patterning device on the substrate; and,
perform a second lithographic exposure using the second off-axis monopole to form a second image of the patterning device on the substrate, wherein the substrate table is configured to move between the first lithographic exposure and the second lithographic exposure such that the first and second images of the patterning device substantially overlap on the substrate.

12. An optical alignment method comprising:

conditioning a radiation beam to form a first off-axis monopole;
diffracting the first off-axis monopole to form zeroth and first diffraction orders;
collecting the zeroth and first diffraction orders;
forming an image using the zeroth and first diffraction orders; and,
detecting the image.

13. A lithographic exposure method comprising:

using the optical alignment method of claim 12 to determine an alignment between a patterning device and a substrate;
using the patterning device to impart the off-axis monopole with a pattern in its cross-section to form a patterned radiation beam; and,
projecting the patterned radiation beam onto the substrate.

14. The lithographic exposure method of claim 13, comprising conditioning the radiation beam to form a second off-axis monopole, wherein the first off-axis monopole and the second off-axis monopole are located in different regions of a pupil plane.

15. The lithographic exposure method of claim 14, comprising:

performing a first lithographic exposure using the first off-axis monopole to form a first image of the patterning device on the substrate;
performing a second lithographic exposure using the second off-axis monopole to form a second image of the patterning device on the substrate; and,
moving the substrate between the first lithographic exposure and the second lithographic exposure such that the first and second images of the patterning device substantially overlap on the substrate.

FIG. 1

FIG. 2A

FIG. 2B

FIG. 3A

FIG. 3B

FIG. 4A

FIG. 4B

500 — Conditioning a radiation beam to form a first off-axis monopole

501 — Diffracting the first off-axis monopole to form zeroth and first diffraction orders

502 — Collecting the zeroth and first diffraction orders and forming an image using the zeroth and first diffraction orders

503 — Detecting the image

FIG. 5

Europäisches
Patentamt

European
Patent Office

Office européen
des brevets

# EUROPEAN SEARCH REPORT

Application Number

EP 22 19 6619

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/003606 A1 (KOMINE NOBUHIRO [JP] ET AL) 5 January 2017 (2017-01-05) | 1-5,8, 12,13 | INV. G03F7/20 G03F9/00 |
| Y | * paragraph [0037] - paragraph [0075] * * figures 3-7,9 * | 6,7, 9-11,14, 15 | |
| Y | WO 2014/139855 A1 (ASML NETHERLANDS BV [NL]) 18 September 2014 (2014-09-18) | 6 | |
| A | * paragraph [0064] - paragraph [0066] * * figure 8a * | 1,12 | |
| Y | US 2008/217726 A1 (TAN SIA KIM [SG] ET AL) 11 September 2008 (2008-09-11) | 7,11,15 | |
| A | * paragraph [0058] - paragraph [0079] * * figures 1-5 * | 1,12 | |
| Y | WO 2020/244854 A1 (ASML NETHERLANDS BV [NL]) 10 December 2020 (2020-12-10) | 9 | |
| A | * paragraph [0098]; figure 2 * | 1,12 | |
| Y | US 2020/103766 A1 (LEE CHIH-JIE [TW] ET AL) 2 April 2020 (2020-04-02) | 10,14 | TECHNICAL FIELDS SEARCHED (IPC) |
| A | * paragraph [0035]; figure 8 * | 1,12 | G03F |

The present search report has been drawn up for all claims

| Place of search | Date of completion of the search | Examiner |
|---|---|---|
| Munich | 9 March 2023 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 19 6619

This annex lists the patent family members relating to the patent documents cited in  the above-mentioned European search report.
The members are as contained in the European Patent Office EDP file on
The European Patent Office is in no way liable for these particulars which are merely given for the purpose of information.

09-03-2023

| Patent document cited in search report | Publication date | Patent family member(s) | Publication date |
|---|---|---|---|
| US 2017003606 A1 | 05-01-2017 | KR 20170003359 A | 09-01-2017 |
| | | TW 201701053 A | 01-01-2017 |
| | | US 2017003606 A1 | 05-01-2017 |
| WO 2014139855 A1 | 18-09-2014 | CN 105051611 A | 11-11-2015 |
| | | JP 6114411 B2 | 12-04-2017 |
| | | JP 2016515221 A | 26-05-2016 |
| | | KR 20150130501 A | 23-11-2015 |
| | | TW 201445613 A | 01-12-2014 |
| | | US 2015370174 A1 | 24-12-2015 |
| | | WO 2014139855 A1 | 18-09-2014 |
| US 2008217726 A1 | 11-09-2008 | SG 145661 A1 | 29-09-2008 |
| | | SG 165341 A1 | 28-10-2010 |
| | | US 2008217726 A1 | 11-09-2008 |
| WO 2020244854 A1 | 10-12-2020 | CN 113966490 A | 21-01-2022 |
| | | WO 2020244854 A1 | 10-12-2020 |
| US 2020103766 A1 | 02-04-2020 | CN 110967934 A | 07-04-2020 |
| | | KR 20200037055 A | 08-04-2020 |
| | | TW 202026755 A | 16-07-2020 |
| | | US 2020103766 A1 | 02-04-2020 |
| | | US 2021286274 A1 | 16-09-2021 |

EPO FORM P0459

For more details about this annex : see Official Journal of the European Patent Office, No. 12/82